# EUROPEAN PATENT APPLICATION

(11) **EP 2 299 589 A2**
(43) Date of publication of application: **23.03.2011**
(21) Application number: 10163390.7
(22) Date of filing: 20.05.2010
(51) Int. Cl.: H03F 1/02

(54) **Audio processing apparatus and method**

(30) Priority: 09.09.2009 KR 20090084926
(71) Applicant: Samsung Electronics Co., Ltd., Suwon-si, Gyeonggi-do 442-742 (KR)
(72) Inventor: Yoon, Jong-taek, Gyeonggi-do (KR); Kim, Hag-do, Gyeonggi-do (KR)
(74) Representative: D'Halleweyn, Nele Veerle Trees Gertrudis

(57) **Abstract**

An audio processing apparatus includes an amplification unit to receive and amplify an audio signal, a power source unit to provide power source to the amplification unit, and a signal processing unit to adjust the power source level provided to the amplification unit based on audio signal level and power source level. Accordingly, high-quality audio may be reproduced.

## Description

The present general inventive concept relates to an audio processing apparatus and a method thereof, and more particularly, to an audio processing apparatus to reduce audio distortion and improve dynamic range and a method thereof.

Recently, digital amplifiers are replacing analog amplifiers as it becomes possible to realize a small and light amplifier which may directly receive a digital input and perform various pre-processing operations.

Generally, a digital amplifier is used to output an analog signal or a digital signal to a speaker. In order to do this, a digital amplifier uses a digital signal processor (DSP) to process a compressed/non-compressed signal or an analog/digital signal. The DSP demodulates a compressed signal into a non-compressed signal, and outputs the non-compressed signal to a pulse-controlled modulation signal through sound field processing.

A conventional amplifier has used an automatic gain limit (AGL) method when the level of an audio signal which has been signal-processed by the DSP is excessive. However, the AGL method reduces dynamic range, or a ratio between a lowest sound level and a highest sound level, and thus delivers unnatural sound to a user.

In order to address the above issues, several methods are suggested including connecting an amplification stage to power source to prevent dynamic range from being reduced. However, these methods are incapable of dealing with the instant change of sound volume and thus cause audio distortion of the output sound.

### SUMMARY OF THE INVENTION

The present general inventive concept provides an audio processing apparatus to reduce audio distortion and improve dynamic range and a method thereof.

Additional aspects and utilities of the present general inventive concept will be set forth in part in the description which follows and, in part, will be obvious from the description, or may be learned by practice of the general inventive concept.

Features and/or utilities of the present general inventive concept may be realized by an audio processing apparatus including an amplification unit to receive and amplify an audio signal, a power source unit to provide the amplification unit with power source, and a signal processing unit to adjust power source level provided to the amplification unit based on the audio signal level and the power source level.

If the audio signal level exceeds the power source level, the signal processing unit may adjust the power source level so that the power source level provided to the amplification unit exceeds the audio signal level.

The signal processing unit may transmit an audio signal input from outside to the amplification unit after performing pre-processing on it, transmit a control signal to adjust the power source level to the power source unit, and transmit the control signal and the pre-processed audio signal to the power source unit and the amplification unit respectively so that the control sing and the pre-processed audio signal have a predetermined time difference.

The predetermined time difference may be difference between time taken to perform post-processing on the pre-processed audio signal and time taken to perform processing on the control signal.

The audio signal level may be volume of the audio signal.

The power source level may be voltage of the power source.

Features and/or utilities of the present general inventive concept may also be realized by an audio processing method including adjusting power source level required to amplify the audio signal based on an audio signal level and receiving and amplifying the audio signal based on the power source level.

If the audio signal level exceeds the power source level, adjusting the power source level may include adjusting the power source level so that power source level provided to the amplification unit exceeds the audio signal level.

The adjusting and the amplifying may have a predetermined time difference.

The predetermined time difference may be difference between time taken to perform post-processing on the pre-processed audio signal and time taken to perform processing on the control signal.

The audio signal level may be volume of the audio signal.

The power source level may be voltage of the power source.

Features and/or utilities of the present general inventive concept may also be realized by an audio processing apparatus including a digital signal processor to receive an audio input signal and a power supply feedback signal and to output a processed audio signal and a power supply control signal, an amplifier to amplify the processed audio signal, and a power supply to receive the power supply control signal and to adjust a power output supplied to the amplifier according to the power supply control signal.

The digital signal processor may output the power supply control signal to adjust the power supply output to correspond to the processed audio signal.

The digital signal processor includes a delay circuit to delay output of the processed audio signal to correspond to the power supply control signal.

The delay circuit may delay the processed audio signal for a period of time corresponding to a difference between a time required to process the power supply control signal to control the power level output to the amplifier and a time required to process the processed audio signal to input to the amplifier.

The audio processing apparatus may further include a first digital-to-analog converter to convert the processed audio signal to an analog signal to output to the amplifier, and a second digital-to-analog converter to convert the power supply control signal to an analog signal to input to the power supply.

The processed audio signal and the power supply control signal may be output via separate output terminals.

Features and/or utilities of the present general inventive concept may also be realized by a digital signal processor including an audio signal processing unit to receive an audio signal and to output a processed audio signal and a power supply control signal generator to receive a signal corresponding to a power output supplied to an amplifier and to output a power supply control signal corresponding to the processed audio signal.

The digital signal processor may further include a delay generating circuit to delay output of the processed audio signal to correspond to the power supply control signal.

The delay generating circuit may generate a delay having a duration that corresponds to a difference in a time required to process the power supply control signal to adjust a power output supplied to an amplifier and a time required to supply the processed audio signal to an amplifier.

The digital signal processor may further include first and second output terminals corresponding to the processed audio signal and the power supply control signal, respectively.

Features and/or utilities of the present general inventive concept may also be realized by an audio system including an audio signal generator to generate an audio signal, an audio processing apparatus, and a sound output unit to receive the amplified processed audio signal and to output a corresponding sound. The audio processing apparatus may include a digital signal processor to receive the audio input signal from the audio signal generator and a power supply feedback signal and to output a processed audio signal and a power supply control signal, an amplifier to amplify the processed audio signal, and a power supply to receive the power supply control signal and to adjust a power output supplied to the amplifier according to the power supply control signal.

The audio signal generator may be one of a CD, DVD, hard disk, mp3 storage device, memory chip, and cassette.

The digital signal processor may output the power supply control signal to adjust the power supply output to correspond to the processed audio signal.

The digital signal processor may include a delay circuit to delay output of the processed audio signal to correspond to the power supply control signal.

The delay circuit may delay the processed audio signal for a period of time corresponding to a difference between a time required to process the power supply control signal to control the power level output to the amplifier and a time required to process the processed audio signal to input to the amplifier.

The audio processing apparatus may further include a first digital-to-analog converter to convert the processed audio signal to an analog signal to output to the amplifier and a second digital-to-analog converter to convert the power supply control signal to an analog signal to input to the power supply.

The processed audio signal and the power supply control signal may be output from the digital signal processor via separate output terminals.

Features and/or utilities of the present general inventive concept may also be realized by a method of controlling an amplifier, the method including receiving an audio signal, receiving a power supply feedback signal, and adjusting a power supply output according to the received audio signal and the power supply feedback signal.

Adjusting the power supply output may include determining if the received audio signal exceeds a threshold corresponding to the power supply output and, if the received audio signal exceeds the threshold, increasing the power supply output to exceed the received audio signal.

The method may further include, after increasing the power supply output to exceed the received audio signal, decreasing the power supply output to the threshold once the received audio signal no longer exceeds the threshold.

Adjusting a power supply output according to the received audio signal may include generating a power supply control signal.

The method may further include delaying output of the received audio signal to correspond to a time required to adjust a power supply output according to the power supply control signal.

The method may further include generating a processed audio signal corresponding to the received audio signal.

The method may further include outputting a sound corresponding to the received audio signal.

### BRIEF DESCRIPTION OF THE DRAWINGS

These and/or other aspects and utilities of the present general inventive concept will become apparent and more readily appreciated from the following description of the embodiments, taken in conjunction with the accompanying drawings of which:

FIG. 1 is a block diagram illustrating an audio processing apparatus according to an exemplary embodiment of the present general inventive concept;

FIG. 2A to FIG. 2C are views illustrating an audio signal and voltage of power source when an audio signal and a power source controlling signal are transmitted through a separate path;

FIG. 3A and FIG. 3B are views illustrating distortion when an audio signal and a power source controlling signal are transmitted through a separate path;

FIG. 4 is a flow chart provided to explain a method of processing audio according to an exemplary embodiment of the present general inventive concept;

FIG. 5 is a block diagram illustrating the structure of an audio processing apparatus according to another exemplary embodiment of the present general inventive concept;

FIG. 6 is a flow chart provided to explain a method of processing audio according to another exemplary embodiment of the present general inventive concept;

FIGS. 7A-7C illustrate embodiments of an audio processing system according to the present general inventive concept; and

FIG. 8 illustrates a block diagram of functional units of a digital signal processor according to an embodiment of the present general inventive concept.

### DETAILED DESCRIPTION OF THE PREFERRED EMBODIMENTS

Reference will now be made in detail to the embodiments of the present general inventive concept, examples of which are illustrated in the accompanying drawings, wherein like reference numerals refer to the like elements throughout. The embodiments are described below in order to explain the present general inventive concept by referring to the figures.

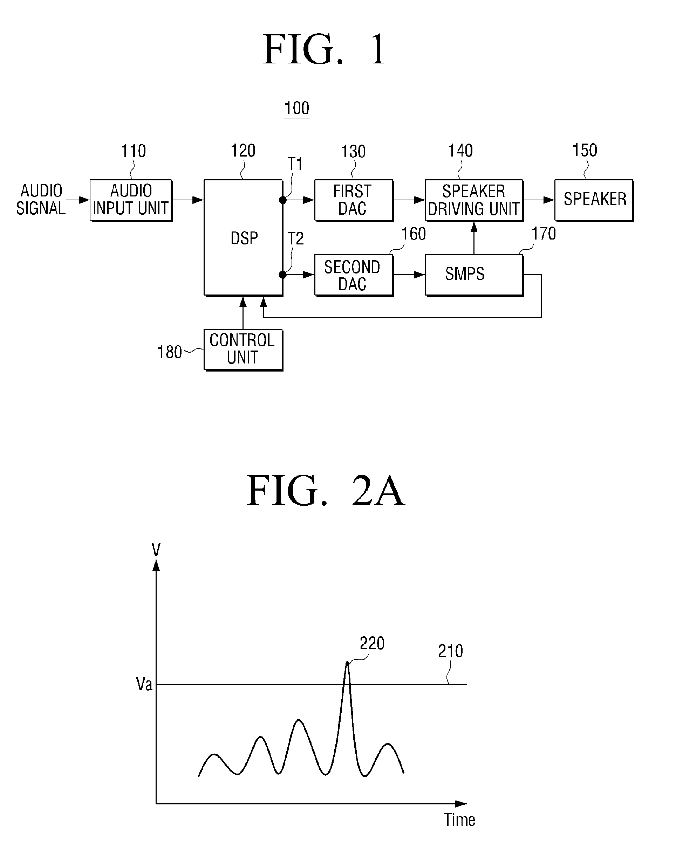

FIG. 1 is a block diagram illustrating an audio processing apparatus 100 according to an exemplary embodiment of the present general inventive concept. The present audio processing apparatus 100 uses a digital amplifier, generates a signal to drive a speaker and a signal to provide power source separately, and outputs audio with minimum level of distortion.

As illustrated in FIG. 1, the audio processing apparatus 100 comprises an audio input unit 110, a DSP 120, a first digital-to-analog converter (DAC) 130, a speaker driving unit 140, a speaker 150, a second DAC 160, a switch-mode power supply (SMPS) 170, and a control unit 180.

The audio input unit 110 receives an audio signal stored in the audio processing apparatus 100 or an audio signal transmitted from an external apparatus connected with the audio processing apparatus 100. The audio signal may be non-compressed or compressed like a bit stream. The audio input unit 110 transmits the audio signal to the digital signal processor (DSP) 120.

The DSP 120 performs signal processing on the audio signal input to the audio input unit 110. Specifically, if a compressed audio signal such as a bit stream is input, the DSP 120 decompresses the audio signal and converts the decompressed audio signal into a pulse coded modulation (PCM) signal. If a non-compressed audio signal is input or a compressed audio signal is decompressed, the DSP 120 converts the non-compressed audio signal into a pulse coded modulation (PCM) signal.

In order for digital amplification, the DSP 120 transmits the PCM signal to the first DAC 130 via a first terminal T1. The first DAC 130 converts the PCM signal into an analog signal to input into a speaker driving unit 140, such as an amplifier. The speaker driving unit 140 may amplify the audio signal and output the amplified signal to a speaker 150 or other sound output unit. The digital signal processor 120 also controls the power source 170, or switch-mode power supply, of the speaker driving unit 140 to prevent audio distortion by generating a control signal to control the power source 170 and transmitting the control signal to the second DAC 160 via a second terminal T2. The second DAC 160 converts the control signal to an analog signal which is input to the power source, or SMPS, 170. The SMPS 170 then adjusts the power level input to the speaker driving unit 140 accordingly.

The DSP 120 generates the power control signal based on a power source level feedback signal received from the SMPS 170 and either the audio input signal or the processed PCM signal based on the audio input signal. Particularly, if the PCM signal level is higher than the power source level output to the speaker driving unit 140 from the SMPS 170, the DSP generates the control signal to adjust the power source level to be provided to the speaker driving unit 140 so that the voltage level output from the SMPS 170 to the speaker driving unit 140 is more greater than the level of the audio signal.

In addition, the DSP 120 transmits the PCM signal to the first DAC 130 and the control signal to the second DAC 160 with a predetermined time interval, since that it takes more time to perform power source control than signal-processing on an audio signal. That is, if control signals for a PCM signal and power source control are transmitted to the first DAC 130 and the second DAC 160 simultaneously, then the power source cannot be controlled appropriately since signal-processing on the PCM signal is faster than performing power source control. Consequently, the portion of the audio signal that is greater than the voltage level of the power source corresponding to the power source feedback signal received by the DSP may be transmitted to the speaker driving unit 140 before the SMPS 170 is able to increase the voltage level output to the speaker driving unit 140.

Accordingly, the DSP 120 may transmit the control signal to the second DAC 160 before transmitting the corresponding pulse-controlled modulation signal to the first DAC 130. The time difference between transmitting the control signal and the PCM signal may correspond to the time difference of signal-processing to control the power source and signal-processing to control the audio signal.

The control unit 180 may control overall operation of the audio processing apparatus 100 to prevent the distortion of audio output to the speaker 150. In particular, the control unit 180 controls the DSP 120 to generate a control signal to adjust power source level to be provided to the SMPS 170 as feedback and transmits the PCM signal to the first DAC 130 and the control signal to the second DAC 160 respectively, having a predetermined time interval.

As described above, a signal for processing audio and a signal for controlling power source are transmitted through a separate path with a predetermined time interval, and thus the problem of creating audio distortion and narrowing dynamic range may be prevented.

FIG. 2A to FIG. 2C are views illustrating an audio signal and voltage of power source when an audio signal and a power source controlling signal are transmitted through a separate path.

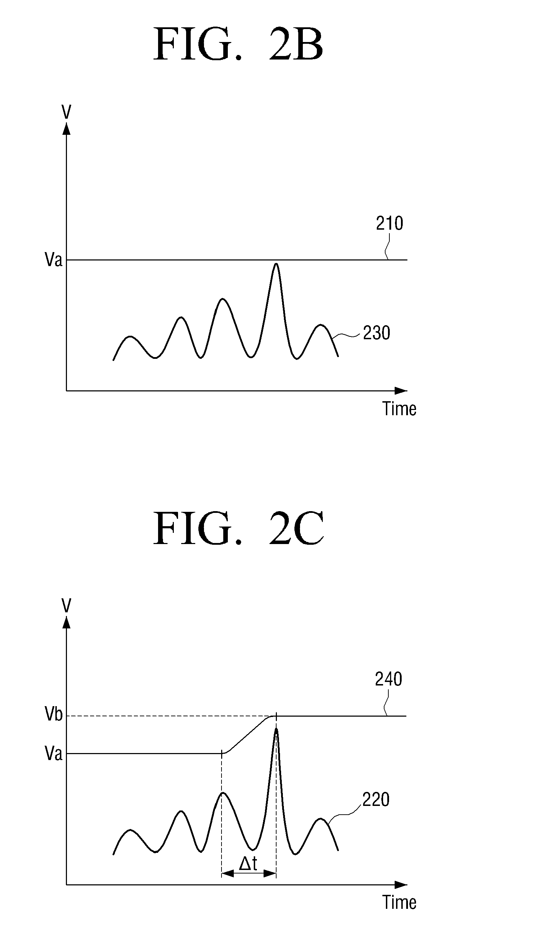

As illustrated in FIG. 2A, if voltage level 210 of power source provided by the SMPS 170 is Va, and level of the audio signal 220 transmitted to the speaker driving unit 140 from the first DAC 130 goes up temporarily, a conventional audio processing apparatus or a conventional digital amplifier using an automatic gain limit (AGL) method reduces the level (volume) of the audio signal 230 below the voltage level 210 as illustrated in FIG. 2B, thereby causing audio distortion.

The audio processing apparatus 100, according to an exemplary embodiment of the present general inventive concept, determines whether the level (volume) of the audio signal 220 would go up temporarily or not based on voltage received from the SMPS 170 as feedback, as illustrated in FIG. 2A, and if it is determined that the level (volume) of the audio signal 220 goes up temporarily, the audio processing apparatus 100 raises the level of the power source controlling signal a predetermined time (Δt) faster than the audio signal without lowering the level of the audio signal, as illustrated in FIG. 2C.

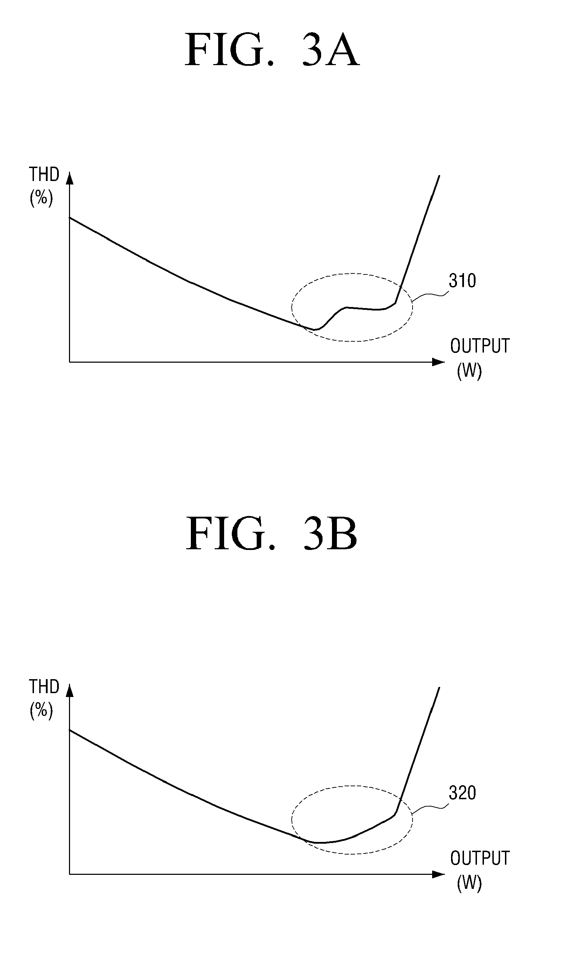

Accordingly, it is possible to respond to the change of an audio signal instantly, thereby preventing the distortion of the audio signal. The distortion will be explained with reference to FIG. 3A and FIG. 3B.

FIG. 3A and FIG. 3B illustrate distortion when an audio signal and a power source controlling signal are transmitted through a separate path.

As illustrated in FIG. 3A, if there is an instant change in audio signal level, a conventional audio processing apparatus or a conventional digital amplifier cannot respond to the instant change, thereby causing total harmonic distortion (THD) in the region 310.

However, as illustrated in FIG. 3B, the audio processing apparatus 100, according to an exemplary embodiment of the present general inventive concept, transmits an audio signal and a power source controlling signal through a separate path and raises the level of the power source controlling signal a predetermined time (Δt) faster than the audio signal so as to promptly respond to the instant change in audio signal level, thereby preventing THD in the region 320 of the signal.

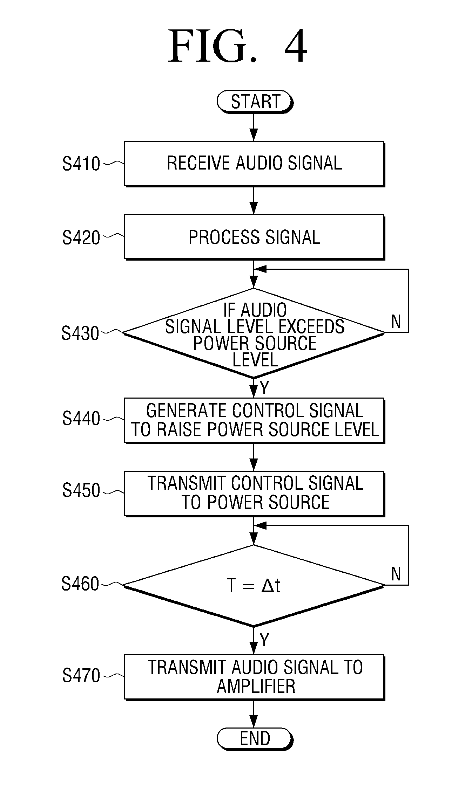

FIG. 4 is a flow chart provided to explain a method of processing audio according to an exemplary embodiment of the present general inventive concept.

First of all, the audio input unit 110 receives an audio signal stored in the audio processing apparatus 100 or an audio signal transmitted from an external apparatus connected with the audio processing apparatus 100 (S41 0).

The audio processing apparatus 100 performs signal-processing on the received audio signal such as decompressing and PCM demodulation (S420) and determines whether the level of the audio signal is higher than the level of power source (S430).

If it is determined that the audio signal level is higher than the power source level (S430-Y), the audio processing apparatus 100 generates a control signal to raise the voltage level of the power source (S440) and transmits the generated control signal to the power source (S450).

After the control sign is transmitted to the power source and a predetermined time (Δt) elapses (S460-Y), the audio processing apparatus 100 transmits the generated audio signal to an amplifier (S470).

As described above, a signal for processing audio and a signal for controlling power source are transmitted through a separate path with a predetermined time interval, and thus the problem of creating audio distortion and narrowing dynamic range may be prevented.

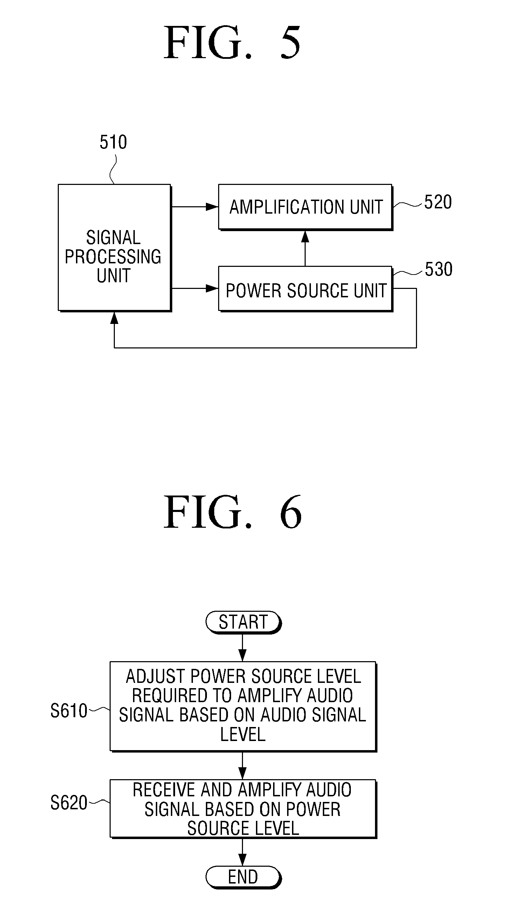

FIG. 5 is a block diagram illustrating the structure of an audio processing apparatus according to another exemplary embodiment of the present general inventive concept. The audio processing apparatus, according to an exemplary embodiment of the present general inventive concept, comprises a signal processing unit 510, an amplification unit 520, and a power source unit 530.

The signal processing unit 510 adjusts the power source level to be provided to the amplification unit 520 based on the audio signal level and the power source level received from the power source unit 530 which will be described later.

The amplification unit 520 receives and amplifies an audio signal.

The power source unit 530 provides the amplification unit with power source and transmits power source or power source level to the signal processing unit 510.

FIG. 6 is a flow chart provided to explain a method of processing audio according to another exemplary embodiment of the present general inventive concept.

In order to process audio, the power source level required to amplify an audio signal is adjusted based on the audio signal level (S61 0).

Subsequently, the audio signal is received and amplified based on the power source level (S520).

Accordingly, it is possible to reproduce high-quality audio.

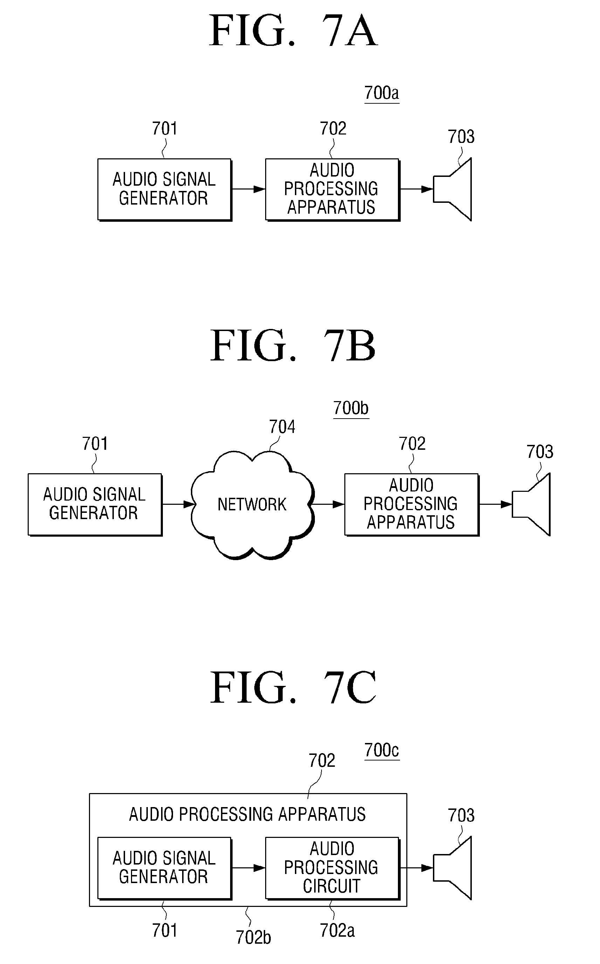

FIGS. 7A-7C illustrate embodiments of audio processing systems according to the present general inventive concept. In FIG. 7A, the audio processing system 700a includes an audio signal generator 701 that generates an audio signal and transmits the audio signal to the audio processing apparatus 702, which is similar to the audio processing apparatus 100 of FIG. 1. Upon processing the audio signal, the audio processing apparatus 702 outputs the audio signal to a sound output unit 703, such as a speaker.

The audio signal generator 701 may include a computer such as a PC or a server, a media device such as an mp3 player or other personal music file storage device, a CD player, DVD player, or other device capable of storing or generating an audio signal. The audio signal generator 701 may include one or more storage devices such as a CD, DVD, memory chip, hard drive, or other storage device to store an audio signal or an audio file capable of generating an audio signal. Alternatively, the audio signal generator 701 may include a musical instrument, such as a keyboard, guitar, wind instrument, or any other instrument capable of generating an audio signal or a music-based file.

The audio signal generator 701 may be connected to the audio processing apparatus 702 via one or more wires or cables, wirelessly via cellular, Bluetooth, or other wireless connection or network, or via any combination of wired and wireless transmission devices. Similarly, the audio processing apparatus 702 may be connected to the sound output unit 703 via wires or wirelessly.

As illustrated in FIG. 7B, the audio processing system 700b may include the audio signal generator 701 connected to the audio processing apparatus 702 via a network 704, such as a local area network or a wide area network, including a wired network, a wireless network, a cellular network, the Internet, or any other network capable of transmitting audio signals.

Alternatively, as illustrated in FIG. 7C, the audio processing system 700c may include the audio signal generator 701 located within the audio processing apparatus 702. The audio signal generator may transmit the audio signal to the audio processing circuit 702a of the audio processing apparatus 702, and the audio processing circuit 702a may be similar to the audio processing apparatus 100 of FIG. 1. The audio processing apparatus 702 may include one or more semiconductor or other electronic chips, including memory, processing, and logic circuits. The boundary 702b of the audio processing apparatus 702 may represent an edge of a semiconductor chip or packaging or an outer shell, frame, or cover of the audio processing apparatus 702.

For example, when the audio signal generator 701 is located within the audio processing apparatus 702, the audio signal generator 701 may include an audio test or configuration signal to configure the voltage output level of the power supply to correspond to a predetermined output range of an audio signal.

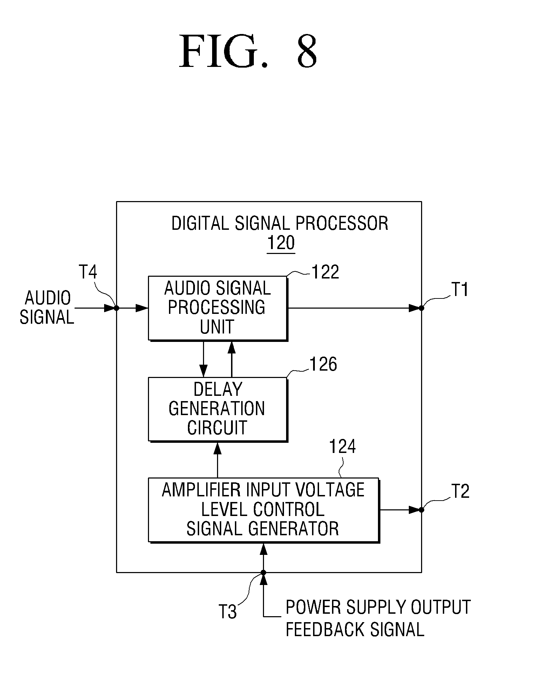

FIG. 8 illustrates an example of a digital signal processor according to an embodiment of the present general inventive concept. The digital signal processor 120 may include an audio signal processing unit 122 to receive an input audio signal via a first terminal T4 and to output a processed audio signal via a second terminal T1. The DSP 120 may include an amplifier input voltage level control signal generator 124 to receive a power supply output feedback signal via a terminal T3 and to output a power supply output voltage control signal via a terminal T2.

A delay generation circuit 126 may delay output of the processed audio signal to the terminal T1 so that the output processed audio signal corresponds to the controlled power supply output voltage. The delay generation circuit 126 may include memory having a predetermined value stored therein, or it may include processing circuitry such as a processor and logic to receive data regarding the audio signal and the power supply output voltage level and to calculate a delay time.

For example, if it is determined that the voltage level output from the power supply should be increased by a predetermined amount, the delay generation circuit may determine how long it would take to process the audio signal in a stage after the processed audio signal is transmitted from terminal T1 and how long it would take to control the power supply to adjust the output voltage level to the desired level. The delay generation circuit 126 may then delay output of the processed audio signal by the calculated value.

Although a few embodiments of the present general inventive concept have been shown and described, it will be appreciated by those skilled in the art that changes may be made in these embodiments without departing from the principles and spirit of the general inventive concept, the scope of which is defined in the appended claims and their equivalents.

## Claims

1. An audio processing apparatus, comprising:
an amplification unit (520) adapted to receive and amplify an audio signal;
a power source unit (530) adapted to provide the amplification unit with power source; and
a signal processing unit (510) adapted to adjust power source level provided to the amplification unit based on the audio signal level and the power source level.

2. The audio processing apparatus of claim 1, wherein the signal processing unit (510), if the audio signal level exceeds the power source level, adjusts the power source level so that the power source level provided to the amplification unit exceeds the audio signal level.

3. The audio processing apparatus of claim 2, wherein the signal processing unit (510) transmits an audio signal input from outside to the amplification unit after performing pre-processing on it, transmits a control signal to adjust the power source level to the power source unit, and transmits the control signal and the pre-processed audio signal to the power source unit and the amplification unit respectively so that the control sing and the pre-processed audio signal have a predetermined time difference.

4. The audio processing apparatus of claim 3, wherein the predetermined time difference is difference between time taken to perform post-processing on the pre-processed audio signal and time taken to perform processing on the control signal.

5. The audio processing apparatus of one of claim 1 to claim 4, wherein the audio signal level is volume of the audio signal.

6. The audio processing apparatus of one of claim 1 to claim 5, wherein the power source level is voltage of the power source.

7. An audio processing method, comprising:
adjusting power source level required to amplify the audio signal based on an audio signal level; and
receiving and amplifying the audio signal based on the power source level.

8. The audio processing method of claim 7, wherein the adjusting, if the audio signal level exceeds the power source level, adjusts the power source level so that power source level provided to the amplification unit exceeds the audio signal level (S430, S440).

9. The audio processing method of claim 8, wherein the adjusting and the amplifying have a predetermined time difference.

10. The audio processing method of claim 9, wherein the predetermined time difference is difference between time taken to perform post-processing on the pre-processed audio signal and time taken to perform processing on the control signal.

11. The audio processing method of one of claim 7 to claim 10, wherein the audio signal level is volume of the audio signal.

12. The audio processing method of one of claim 7 to claim 11, wherein the power source level is voltage of the power source.
